# EUROPÄISCHE PATENTSCHRIFT

(11) **EP 0 490 068 B1**
(45) Veröffentlichungstag und Bekanntmachung des Hinweises auf die Patenterteilung: **11.10.1995**
(21) Anmeldenummer: 91118100.6
(22) Anmeldetag: 24.10.1991
(51) Int. Cl.: H01J 37/304, H01J 37/305, H01J 37/30, H01J 37/04

(54) **Verfahren zum Zentrieren eines Elektronenstrahles**
Method for centering an electron beam
Procédé pour centrer une faisceau d'électrons

(30) Priorität: 13.12.1990 CH 3955/90
(43) Veröffentlichungstag der Anmeldung: 17.06.1992
(73) Patentinhaber: BALZERS AKTIENGESELLSCHAFT, 9496 Balzers (LI)
(72) Erfinder: Schmid, Roland, A-6811 Göfis (AT); Kaufmann, Helmut, FL-9495 Triesen (LI)
(74) Vertreter: Troesch Scheidegger Werner AG

(56) Entgegenhaltungen:
- EP-A- 0 379 739
- EP-A- 0 381 912
- PATENT ABSTRACTS OF JAPAN vol. 9, no. 56 (E-302)(1779) 12. März 1985;& JP-A-59195825

## Beschreibung

Die vorliegende Erfindung betrifft ein Verfahren zum Führen und Zentrieren eines Elektronenstrahles mittels eines zur Achse des Elektronenstrahls orthogonalen Magnetfeldes in einer Vakuumbeschichtungsanlage, wobei der Elektronenstrahl in einer Vakuumkammer von einer Kathode zu einer Rohmaterialquelle geführt und dort ein Brennfeld erzeugt wird, und mittels des Elektronenstrahles die Oberfläche der Rohmaterialquelle erwärmt und abgeschmolzen wird und die Rohmaterialquelle entsprechend der Abschmelzung nachgeschoben wird, und wobei mit dem Magnetfeld der Elektronenstrahl in eine Rotationsbewegung um eine Achse etwa parallel zur Elektronenstrahlachse versetzt wird, sowie eine Vorrichtung zur Durchführung dieses Verfahrens.

Es sind verschiedene Verfahren bekannt, um die Verdampfung von Beschichtungsmaterialien zu ermöglichen und in einer Vakuumkammer die Oberflächen von Substraten mit diesem Material zu beschichten. Es ist auch bekannt, in die Vakuumkammer zusätzliche Reaktivgase, wie Stickstoff oder Sauerstoff einzuführen, wodurch dann Oberflächenüberzüge aus entsprechenden Verbindungen entstehen. In der deutschen Patentschrift Nr. 28 23 876 ist ein derartiges Verfahren und eine Vorrichtung beschrieben. Dabei ist in einer Vakuumkammer konzentrisch um die Hauptachse ein Substratträger angeordnet, welcher die zu beschichtenden Teile trägt. Dabei kann es sich um Werkzeuge wie Fräser oder Bohrer oder um andere Objekte handeln, welche mit einer Oberflächenschicht versehen werden sollen, welche besondere mechanische, chemische oder optische Eigenschaften aufweisen soll. Im Zentrum der Anlage wird entlang der Längsachse der Vakuumkammer ein Elektronenstrahl geführt, welcher von einer Kathodenanordnung ausgeht und auf eine Rohmaterialquelle auftrifft. Durch die hohe Energie des Elektronenstrahles wird die Oberfläche der Rohmaterialquelle aufgeschmolzen und entsprechend dem beschriebenen Verfahren auf die Substrate aufgebracht. Der Elektronenstrahl wird mit Hilfe eines Magnetfeldes gebündelt und auf das Zentrum der Vakuumkammer ausgerichtet. Der Substratträger und die am Substratträger angeordneten zu beschichtenden Objekte stören dieses Magnetfeld, und diese Störungen haben zur Folge, dass der Elektronenstrahl abgelenkt und dadurch die Rohmaterialquelle nicht mehr in der gewünschten Weise beaufschlagt wird. Zusätzliche Schwierigkeiten ergeben sich, wenn der Substratträger oder die zu beschichtenden Objekte während des Beschichtungsvorganges rotiert oder in anderer Weise bewegt werden. In diesem Falle verändern sich die Beeinflussungen des Magnetfeldes laufend, und der Elektronenstrahl wird ungleichförmig ausgelenkt und gestört. Dies hat zur Folge, dass die Rohmaterialquelle ungleichförmig beaufschlagt und aufgeschmolzen wird. Der vom Elektronenstrahl erzeugte Brennfleck kann dabei im Extremfall auch ausserhalb der Rohmaterialquelle auf die umliegenden Halterungen auftreffen, was zu entsprechenden Erwärmungen und bei ungenügender Kühlung zu Beschädigungen dieser Anlagenbauelemente führen kann. Bei der bekannten Vorrichtung wird eine Rohmaterialquelle verwendet, welche in einem Tiegel angeordnet ist und nur eine bestimmte Menge von Beschichtungsmaterial enthalten kann.

Es ist auch bekannt, bei Anlagen mit hoher Verdampfungsrate als Rohmaterialquelle einen Barren oder eine Stange einzusetzen, welche laufend durch den Boden des Tiegels nachgeschoben werden kann. Diese Rohmaterialstange bildet die Anode und bei unbeeinflusstem Magnetfeld trifft der durch den Elektronenstrahl gebildete Brennfleck auf das Zentrum der Rohmaterialstange und bewirkt eine gleichmässige Aufschmelzung der Oberfläche. Wird der Elektronenstrahl aus dem Zentrum abgelenkt, so schmilzt die Stange einseitig ab, und es bildet sich ein einseitiger teigiger Kragen. Dieser einseitige Kragen ist auch weniger gut gekühlt, da er weiter von der gekühlten Halterung entfernt ist. Der teigige Teil des Kragens reagiert mit dem in der Vakuumkammer vorhandenen Reaktivgas, und die entstehende Verbindung hat zumeist einen höheren Schmelzpunkt als das reine Material. Dies führt zu Störungen des Beschichtungsprozesses, da dadurch die Verdampfungsrate verändert und der Abschmelzvorgang gestört wird. Dies kann zur Folge haben, dass der Beschichtungsvorgang unterbrochen werden muss und dadurch die zu beschichtenden Objekte eine minderwertige Qualität aufweisen oder gar ausgeschieden werden müssen.

Die sich aus dem oben beschriebenen Sachverhalt ergebende Aufgabe, nähmlich das Zentrieren des Elektronenstrahles während des Beschichtungsvorganges zu ermöglichen, um einen gleichmässigen Aufschmelzvorgang an der Oberfläche der Rohmaterialquelle zu erzeugen, liegt der EP-OS-0381 912 zugrunde, in welcher ein Verfahren zum Zentrieren des Elektronenstrahles mittels einem quer zur Achse des Elektronenstrahl rotierenden Magnetfeld vorgeschlagen wird. Dieses rotierende Magnetfeld kann dabei zusätzlich durch ein stationäres Magnetfeld überlagert werden, für die zusätzliche Beeinflussung und Positionierung des Elektronenstrahles, damit die ganze Oberfläche der Rohmaterialquelle gleichförmig abgetragen wird. Die in der EP-OS-0381 912 vorgeschlagene Steuerung resp. Beeinflussung des Magnetfeldes für das Zentrieren resp. Führen des Elektronenstrahles mittels Messen der Verbrauchsrate des Reaktivgases in der Vakuumkammer hat sich nicht bewährt und als unzuverlässig erwiesen und führte nach wie vor zu ungleichmässigem Abtragen des Rohmaterials.

Es ist daher eine Aufgabe der vorliegenden Erfindung eine verbesserte und zuverlässigere Steuerung der Speisgeräte für die die Magnetfelder erzeugenden Spulen zu schaffen, um die Zentrierung resp. Führung des Elektronenstrahles in geeigneter Art und Weise zu bewerkstelligen.

Erfindungsgemäss erfolgt dies mittels einem Verfahren gemäss dem Wortlaut nach Anspruch 1 resp. mittels einer Vorrichtung zur Durchführung des Verfahrens gemäss dem Wortlaut nach Anspruch 8.

Bei dem erfindungsgemässen Verfahren kann die durch den Substrathalter und die Substrate, bzw. durch deren Beeinflussung des Hauptmagnetfeldes erfolgte Auslenkung des Elektronenstrahls von der Idealachse korrigiert werden. Dies geschieht dadurch, dass quer zur Achse des Elektronenstrahles stationäre Magnetfelder erzeugt werden, welche den Elektronenstrahl auf das Zentrum der Rohmaterialquelle positionieren. Die Achsen der beiden Magnetspulen liegen dabei etwa rechtwinklig zueinander und in einer Ebene, welche etwa rechtwinklig zur Achse des Elektronenstrahles verläuft. Die so erzeugten Magnetfelder kompensieren die durch die ferromagnetischen Substrate hervorgerufene Beeinflussung des Hauptfeldes. Den stationären Magnetfeldern überlagert kann auf den gleichen Achsen, auf welchen die Magnetspulen für die stationären Magnetfelder angeordnet sind, zusätzlich ein rotierendes Magnetfeld erzeugt werden, welches der zusätzlichen Beeinflussung und Positionierung des Elektronenstrahles dient, resp. mittels welchem der Elektronenstrahl mit einem bestimmten Radius um eine Rotationsachse rotiert wird. Das rotierende Magnetfeld wird mittels zweier um 90° versetzter Spulen erzeugt, welche mit um 90° phasenverschobenem Wechselstrom gespiesen werden. Das rotierende Magnetfeld kann aber auch mittels der beiden vorab erwähnten Magnetspulen erzeugt werden, indem diese zusätzlich mit einem um 90° phasenverschobenen Wechselstrom gespiesen werden. Dieses zusätzliche rotierende Magnetfeld ermöglicht es, die Rotationsachse, um welche der Elektronenstrahl rotiert, indem durch die beiden Achsen der Magnetspulen gebildeten Koordinatensystem zu verschieben, bis im optimalen Fall die Rotationsachse in Deckung mit der Achse der Rohmaterialquelle gebracht ist.

Wenn beim Betrieb der Anlage der Elektronenstrahl nicht auf das Zentrum der Rohmaterialquelle fällt, beispielsweise in dem die ferromagnetischen Substrate das von den Spulen erzeugte Hauptfeld verzerren, liegt auch die Rotationsachse, um welchen der Elektronenstrahl rotiert wird, ausserhalb der Achse der Rohmaterialquelle. Dadurch bestreicht der Elektronenstrahl nicht die ganze Oberfläche der Rohmaterialquelle und diese wird ungleichförmig aufgeschmolzen, bzw. abgetragen. Mit anderen Worten brennt die Gasentladung, mit der das Schmelzgut der Verdampferquelle erhitzt wird, nicht auf die Mitte der Verdampferquelle. Der heisseste Bereich ist somit nicht konzentrisch in der Stabmitte der Rohmaterialquelle.

Bei dem erfindungsgemessen Verfahren ist nun eine Videokamera von einem Videosystem auf die Stabmitte der Rohmaterialquelle ausgerichtet. An der Videokamera ist ein Bildauswerter angeschlossen. Dieser Bildauswerter detektiert Helligkeitssignale über einem einstellbaren Schwellenwert und liefert für die Fläche mit Helligkeit über diesem Schwellenwert Signale, die den Schwerpunktskoordinaten dieses Bereiches, bezogen auf das Koordinatensystem der Videokamera entsprechen. Auf diese Art und Weise kann der heisseste Bereich auf der Verdampferquelle lokalisiert werden, der nicht konzentrisch in der Stabmitte ist. Mittels der im Bildauswerter erzeugten Signale werden über einen Rechner die Speisegeräte der orthogonalen um 90° versetzten Spulen zum Zentrieren des rotierenden Magnetfeldes resp. des Elektronenstrahles derart angesteuert, dass der Bereich mit der grössten Helligkeit in der Mitte der Verdampferquelle zu liegen kommt. Dieser Zentriervorgang des Elektronenstrahles kann bereits vor dem Beschichtungsprozess durchgeführt werden und zwar beispielsweise mit einem viertel der vollen Leistung, so dass das Schmelzgut dabei nur erhitzt aber nicht verdampft wird. Entsprechend der durch die Videokamera festgestellten Auslenkung wird der rotierende Elektronenstrahl mit der Rotationsachse in Richtung der Achse der Rohmaterialquelle verschoben, bis die Rotationsachse mit der Achse der Rohmaterialquelle in Deckung gebracht ist.

Ist für den Prozess eine vertikale Tiegelbewegung notwendig, d.h. eine vertikale Bewegung der Verdampferquelle, dann wird die Zentrierung für die untere und obere Tiegelposition vor dem Beschichten durchgeführt. Die Videokamera wird dazu soweit geschwenkt, bis die Verdampferquelle wieder in der Bildmitte zu liegen kommt. Während des Beschichtungsprozesses werden die Spulen mit den beim Zentriervorgang ermittelten Strömen betrieben. Die Gasentladung brennt nun mit der vollen Leistung auf die Mitte des Schmelzgutes. Um ein gleichmässiges Abschmelzen des Stabes zu erreichen werden dem Zentriersignal der beiden Spulen, wie oben erwähnt, Wechselsignale überlagert. Die beiden Wechselsignale sind gegeneinander ebenfalls um 90° phasenverschoben. Durch das dem Gleichfeld überlagerte Drehfeld wandert der Brennfleck um den Mittelpunkt des Stabes und ein gleichmässiges Abschmelzen des Stabes ist sichergestellt. Der Brennfleck kreist so um das Zentrum der Stabmitte der Rohmaterialquelle.

Dieses Verfahren ermöglicht eine automatische Steuerung derartiger Oberflächenbeschichtungsanlagen, bei welchen der Elektronenstrahl durch die eingebrachten Substrate oder die Substrathalter aus der Optimallage ausgelenkt wird. Da das Verfahren und die Vorrichtung selbstregelnd sind, bedarf es keiner Umstellung, wenn andere Substrate oder andere Anordnungen im Bereich des Substratträgers verwendet werden. Durch den um eine Achse rotierende Elektronenstrahl ist es möglich, mit einem relativ kleinen Durchmesser des Elektronenstrahls die ganze Fläche der Rohmaterialquelle zu bestreichen und eine gleichmässige Aufschmelzung und Verdampfungsrate zu erreichen. Diese Anordnung ermöglicht auch, Rohmaterialquellen einzusetzen, welche abhängig von der Abschmelzungs- bzw. Verdampfungsrate kontinuierlich nachgeschoben werden können. Erfindungswesentlich ist dabei, dass jeweils vor erneuter Inbetriebnahme einer derartigen Oberflächenbeschichtungsanlage der Elektronenstrahl mittels dem oben erwähnten, erfindungsgemässen Verfahren unter Verwendung einer Videokamera in die Stabmitte der Rohmaterialquelle ausgerichtet wird.

Die Erfindung wird nun anschliessend anhand einer Ausführungsform und unter Bezug auf die beigefügten Figuren näher erläutert.
Dabei zeigen:
- Fig. 1: einen Längsschnitt durch eine erfindungsgemässe Vakuumbeschichtungsanlage in schematischer Darstellung,
- Fig. 2: die Anordnung der für die Zentrierung des Elektronenstrahls notwendigen Magnetspulen, und
- Fig. 3 - 5: schematisch dargestellt den Einfluss der Magnetfelder auf die Lage des Brennfeckes auf der Verdampfungsquelle.

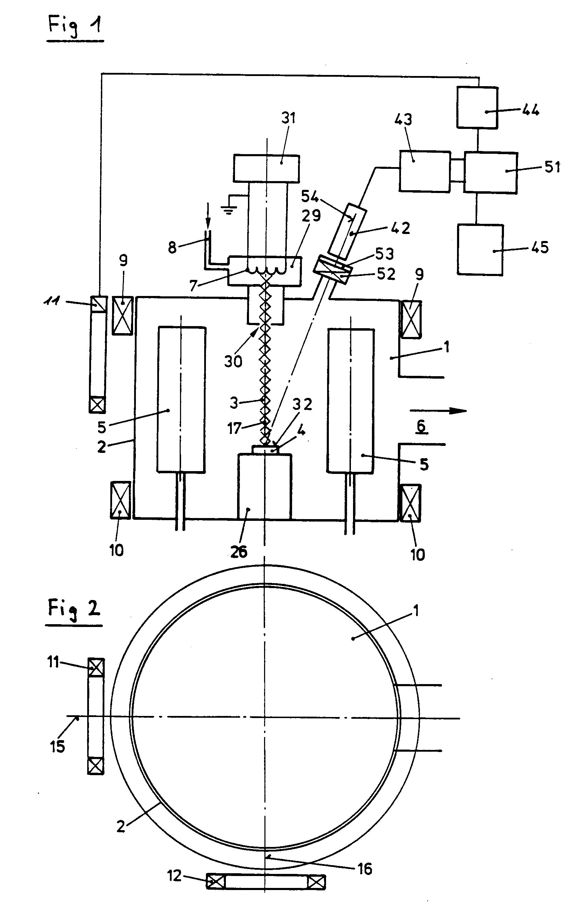

Die Vakuumbeschichtungsanlage gemäss Fig. 1 und 2 besteht aus einem Gehäuse 2, welches eine Vakuumkammer 1 umschliesst. In dieser Vakuumkammer 1 sind ferromagnetische Substrate 5 angeordnet, deren Oberflächen beschichtet werden sollen. Die Substrate 5 sind in nicht dargestellter Weise beweglich, um eine optimale Beschichtung derer Oberflächen zu gewährleisten. Am oberen Teil des Gehäuses 2 befindet sich eine Glühkathodenkammer 29, mit einer Kathode 7 und entsprechender Energiespeiseeinrichtungen 31. Die Glühkathodenkammer 29 ist über eine Oeffnung 30 mit der Vakuumkammer 1 verbunden. Am Boden der Vakuumkammer 1 befindet sich eine Rohmaterialquelle 4. Diese Rohmaterialquelle 4 ist stangenförmig ausgebildet und kann entsprechend dem abgeschmolzenen und verdampften Materialanteil nachgeschoben werden. Dazu ist unterhalb der Rohmaterialquelle 4 eine Vorschubeinrichtung 26 eingebaut. Am Gehäuse 2 ist ein Evakuierungsanschluss 6 angeordnet, über welchem in der Vakuumkammer 1 das gewünschte Vakuum erzeugt werden kann. Im Bereiche der Kathodenkammer 29 befindet sich ein Anschluss für eine Reaktivgasleitung 8, über welchen Reaktivgase, wie z.B. Azethylen, Stickstoff oder Sauerstoff zugeführt werden, welche sich in bekannter Weise mit dem Verdampfungsmaterial verbinden. Wird beispielsweise eine Rohmaterialquelle 4 aus Titan benutzt und über die Reaktivgasleitung 8 Stickstoff zugeführt, so können Titanitrid-Beschichtungen oder bei zusätzlicher Zuführung von Azethylen Titancarbonitrid-Beschichtungen erstellt werden, welche besonders geeignet sind als Werkzeugüberzüge. Zwischen Kathode 7 und der Oberfläche der Rohmaterialquelle 4 wird beim Betrieb der Anlage ein Elektronenstrahl 3 erzeugt, welcher die Oberfläche der Rohmaterialquelle 4 aufschmilzt und deren Material in die Vakuumkammer 1 verdampft.

Zur Führung des Elektronenstrahles 3 sind am Gehäuse 2 Magnetspulen 9 und 10 angebracht, welche ein zur Achse 17 des Elektronenstrahles 3 orthogonales Magnetfeld erzeugen. Mit Hilfe dieses Magnetfeldes wird der Elektronenstrahl 3 gebündelt und geführt. Abhängig von der Beschaffenheit sowie der Form und Grösse der zu beschichtenden Substrate bzw. Objekte wird der Fluss des von den Spulen 9 und 10 erzeugten Magnetfeldes beeinflusst, und dadurch der Elektronenstrahl 3 von der theoretischen Achse 17 abgelenkt. Dies hat zur Folge, dass der vom Elektronenstrahl 3 erzeugte Brennfleck auf der Oberfläche der Rohmaterialquelle 4 nicht mehr im Zentrum dieser Rohmaterialquelle 4 auftrifft und dadurch ein ungleichförmiges Abschmelzen der Rohmaterialquelle 4 erfolgt. Dies hat weiter zur Folge, dass die teigigen Randbereiche, welche ungenügend erwärmt werden, mit dem Reaktivgas reagieren und dadurch Verbindungen bilden, welche erst bei einem höheren Schmelzpunkt aufschmelzen. Dies beeinträchtigt die Funktionsweise und Leistung der Beschichtungsanlage in erheblicher Weise. Nach einer gewissen Zeit muss das Nachschieben der Rohmaterialquelle 4 mit Hilfe der Vorschubeinrichtung 26 unterbrochen werden, da sich in demjenigen Bereich der Oberfläche 32 der Rohmaterialquelle 4, welche vom Elektronenstrahl 3 nicht mehr richtig erhitzt wird, ein überhöhter Kragen ausbildet.

Zur Verhinderung dieser Störungen resp. zur Korrektur des Verlaufes des Elektronenstrahls sind bei der erfindungsgemässen Einrichtung zusätzliche Magnetspulen 11 (X-Spule) und 12 (Y-Spule) angeordnet. Diese Magnetspulen sind im dargestellten Beispiel ausserhalb des Gehäuses 2 angebracht, und zwar in einer Ebene, welche etwa rechtwinklig zur Achse 17 des Elektronenstrahles 3 steht. Die Achsen 15 und 16 der Spulen 11 und 12 liegen in der gleichen Ebene und stehen in einem Winkel von 90° zueinander.

Weiter ist in der erfindungsgemässen Vorrichtung eine Videokamera 42 angeordnet, welche durch eine fensterartige Oeffnung 53 und ein Ventil 52 auf die Stabmitte der Verdampferquelle 4 ausgerichtet ist. Die Videokamera 42 ist um ihre Drehachse 54 schwenkbar gelagert. An der Videokamera 42 ist ein Bildauswerter 43 angeschlossen. Dieser Bildauswerter 43 detektiert Helligkeitssignale über einem einstellbaren Schwellenwert und liefert für die Fläche mit Helligkeit über diesem Schwellwert Signale, die den Schwerpunktkoordinaten dieses Bereiches, bezogen auf das Koordinatensystem der Videokamera entsprechen. Auf diese Art und Weise wird der heisseste Bereich auf der Oberfläche der Verdampferquelle 4, der durch die Gasentladung resp. durch die Erhitzung der Verdampferquelle 4 mittels des Elektronenstrahles erzeugt wird, durch die Videokamera 42 detektiert. Ueber einen Rechner 51, der mit dem Bildauswerter 43 verbunden ist, und die Speisegeräte 44 und 45 werden die orthogonal zueinander angeordneten Zentrierspulen 11 und 12 so angesteuert, resp. das zusätzliche Magnetfeld für die Korrektur des Elektronenstrahles derart erzeugt, dass der Bereich mit der grössten Helligkeit in die Mitte der Verdampferquelle 4 zu liegen kommt Dieser Zentriervorgang mittels dem Videosystem erfolgt vorzugsweise vor dem Beschichtungsprozess, wobei er mit weniger als einem viertel der vollen Leistung durchgeführt werden kann. Dadurch wird das Schmelzgut 4 nur erhitzt, nicht aber verdampft. Dadurch dass die Videokamera 42 um ihre Achse 54 schwenkbar gelagert ist, kann sie bei Vertikalbewegung der Verdampferquelle 4 jeweils an die entsprechende Position der Oberfläche angepasst werden, damit die Videokamera in jedem Fall auf das Zentrum der Verdampferquelle 4 gerichtet ist. Für den Beschichtungsprozess wird das Ventil 52 geschlossen, damit das Fenster 53 nicht bedampft wird. Während des Beschichtungsprozesses werden die Spulen mit den beim Zentriervorgang ermittelten Strömen betrieben. Die Gasentladung brennt nun mit der vollen Leistung auf die Mitte des Schmelzgutes 4. Um ein gleichmässiges Abschmelzen des Schmelzgutes 4 zu erreichen werden dem Zentriersignal der beiden Spulen 11 und 12 Wechselsignale überlagert. Durch das dem Gleichfeld überlagerte Drehfeld wandert der Brennfleck um den Mittelpunkt der Oberfläche der Verdampferquelle 4 und ein gleichmässiges Abschmelzen des Stabes ist sichergestellt. Diese Ueberlagerung erfolgt entweder durch zusätzliche Magnetspulen, welche parallel zu den Magnetspulen 11 und 12 angeordnet sind, oder diese weiteren Magnetspulen sind Bestandteile der Magnetspulen 11 und 12. Auf diese Art und Weise kreist der Brennfleck ca. 4 mal in der Minute um das Zentrum.

In den Figuren 3, 4 und 5 ist der Einfluss der Magnetfelder auf den Elektronenstrahl resp. auf den an der Oberfläche des Schmelzgutes 4 erzeugten Brennfleck dargestellt.

Fig. 3 zeigt die Lage des Brennfleckes auf der Oberfläche des Schmelzgutes 4, bei welchem der Verlauf des Elektronenstrahles nicht korrigiert ist.

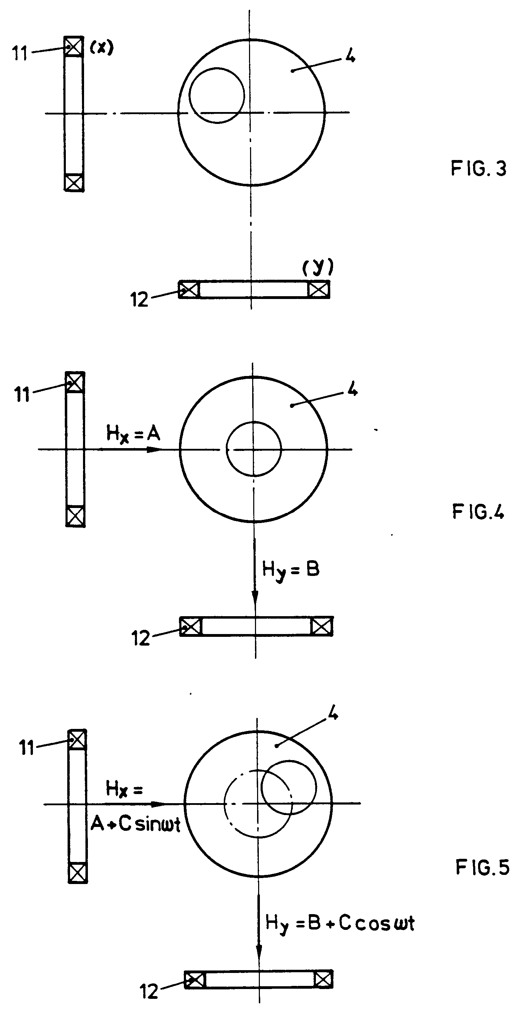

In Fig. 4 wird der Elektronenstrahl durch die Gleichfelder der Spulen 11 und 12 (X und Y Spule) korrigiert, resp. zentriert.

In Fig. 5 wird einerseits der Brennfleck durch das Gleichfeld korrigiert und weiter durch ein Wechselfeld derart überlagert, dass der Brennfleck auf der Verdampferquelle-Oberfläche eine Rotationsbewegung in Pfeilrichtung ausführt.

Die in den Fig. 1 - 5 dargestellte Ausbildung einer erfindungsgemässen Vorrichtung, resp. schematisch dargestellte Durchführung eines erfindungsgemässen Verfahrens ist selbstverständlich nicht auf diese beschränkt, sondern kann in x-beliebiger Art und Weise abgeändert und modifiziert werden. Wesentlich für das erfindungsgemässe Verfahren ist, dass die Lage des Brennfleckes auf einer Verdampferquelle mittels einer Videokamera erfasst wird, und anschliessend derart mittels zusätzlichen orthogonal zueinanderstehenden Magnetspulen korrigiert wird, dass er ins Zentrum der Verdampferquelle zu liegen kommt.

## Patentansprüche

1. Verfahren zum Führen und Zentrieren eines Elektronenstrahles (3) mittels einem zur Achse (17) des Elektronenstrahls (3) orthogonalen Magnetfeldes in einer Vakuum-Beschichtungsanlagen, wobei der Elektronenstrahl (3) in einer Vakuumkammer (1) von einer Kathode (7) zu einer Rohmaterialquelle (4) geführt und dort ein Brennfleck erzeugt wird und mittels des Elektronenstrahles (3) die Oberfläche der Rohmaterialquelle (4) erwärmt und abgeschmolzen wird und die Rohmaterialquelle (4) entsprechend der Abschmelzung nachgeschoben wird, dadurch gekennzeichnet, dass die Abweichung des mittels des Elektronenstrahles (3) erzeugten Brennfleckes vom Zentrum der Rohmaterialquelle (4) mittels einem Videosystem (42,43,52,53) erfasst wird und die so ermittelten Signale für die Ausgestaltung des Magnetfeldes verwendet werden für das Führen resp. Zentrieren des Elektronenstrahles (3).

2. Verfahren wie nach Anspruch 1, dadurch gekennzeichnet, dass zwei gekreuzte Magnetspulen (11,12) für das Zentrieren des Elektronenstrahles (3) verwendet werden.

3. Verfahren wie nach einem der Ansprüche 1 oder 2, dadurch gekennzeichnet, dass das Videosystem eine Videokamera (42) umfasst, die auf die Stabmitte resp. die Mitte der Rohmaterialquelle (4) ausgerichtet wird, und die mit einem Bildauswerter (43) für die Detektion von Helligkeitssignalen auf der Oberfläche der Rohmaterialquelle (4) verbunden ist, mittels welchem Helligkeitssignale über einem einstellbaren Schwellwert detektiert resp. erfasst werden, wobei mittels dieser Signale über einen Rechner (51) die Speisegeräte (44,45) der orthogonalen Magnetspulen (11,12) zum Zentrieren des Elektronenstrahles (3) so angesteuert werden, dass der Bereich mit der grössten Helligkeit auf der Oberfläche der Rohmaterialquelle (4) in die Mitte der Verdampferquelle zu liegen kommt.

4. Verfahren wie nach einem der Ansprüche 1 - 3, dadurch gekennzeichnet, dass für die Zentrierung der Elektronenstrahl (3) mit reduzierter Leistung betrieben wird, derart, dass das Schmelzgut der Verdampferquelle nur erhitzt wird, nicht aber verdampft.

5. Verfahren wie nach einem der Ansprüche 1 - 4, dadurch gekennzeichnet, dass die Videokamera (42) schwenkbar gelagert ist für das Nachstellen resp. des Zentrierens bei Verschiebung der Rohmaterialquelle (4).

6. Verfahren wie nach einem der Ansprüche 1 - 5, dadurch gekennzeichnet, dass das Magnetfeld durch ein mittels einem Wechselsignal erzeugten rotierenden Magnetfeld überlagert wird, zur Erzeugung einer Rotation des Elektronenstrahles (3) um die Achse (17) der Rohmaterialquelle zum Erzielen eines gleichmässigen Abschmelzens der Rohmaterialquelle (4).

7. Verfahren wie nach Anspruch 6, dadurch gekennzeichnet, dass die Achse der Rotationsbewegung mit der Achse (17) der Rohmaterialquelle in Deckung gebracht wird.

8. Vorrichtung für die Durchführung des Verfahrens nach einem der Ansprüche 1 - 7, umfassend Mittel (7,29,30,31) zur Erzeugung eines Elektronenstrahles (3) und Magnetspulen (11,12), die in einer Ebene im Bereiche des Elektronenstrahles (3) angeordnet sind, wobei die Achsen (15, 16) dieser Magnetspulen (11, 12) etwa rechtwinklig zur Achse (17) des Elektronenstrahles (3) und etwa rechtwinklig zueinander verlaufen; dadurch gekennzeichnet dass weiter ein Videosystem vorgesehen ist, umfassend:
- eine Videokamera (42) ausserhalb der Vakuumkammer (1) angeordnet,
- ein verschliessbares Fenster (53) in der Wand der Vakuumkammer für Durchsicht der Videokamera auf die Verdampferquelle (4), wobei die Achse der Videokamera im wesentlichen auf den Mittelpunkt der Quelle gerichtet ist, und
- einen Bildauswerter (43), gekoppelt mit einem Rechner (51) für das Steuern der Speisung (44, 45) der Magnetspulen (11, 12).

## Claims

1. Process for guiding and centring an electron beam (3) by means of a magnetic field orthogonal to the axis (17) of the electron beam (3) in a vacuum coating plant, where the electron beam (3) is guided in a vacuum chamber (1) from a cathode (7) to a raw material source (4) and there generates a focal spot, and the electron beam (3) heats and melts the surface of the raw material source (4) and the raw material source (4) is advanced according to the melting, characterised in that the deviation of the focal spot produced by the electron beam (3) from the centre of the raw material source (4) is detected by means of a video system (42, 43, 52, 53) and the signals thus determined are used to form the magnetic field for guiding or centring the electron beam (3).

2. Process according to Claim 1, characterised in that two crossed magnetic coils (11, 12) are used for centring the electron beam (3).

3. Process according to one of Claims 1 or 2, characterised in that the video system comprises a video camera (42) aligned on the rod centre or the centre of the raw material source (4) and which is connected to an image analyser (43) for detecting brightness signals on the surface of the raw material source (4), by means of which brightness signals above an adjustable threshold value can be detected or captured, where by means of these signals the supply devices (44, 45) of the orthogonal magnetic coils (11, 12) for centring the electron beam (3) can be controlled by a computer (51) such that the area with the greatest brightness on the surface of the raw material source (4) comes to lie in the centre of the vaporization source.

4. Process according to any of Claims 1 to 3, characterised in that for centring purposes the electron beam (3) is operated at reduced power such that the melting product of the vaporization source is only heated and not vaporized.

5. Process according to any of Claims 1 to 4, characterised in that the video camera (42) is mounted to swivel for adjustment or centring as the raw material source (4) shifts.

6. Process according to any of Claims 1 to 5, characterised in that the magnetic field is overlaid by a rotary magnetic field generated by means of an alternating signal to produce a rotation of the electron beam (3) about the axis (17) of the raw material source in order to achieve an even melting of the raw material source (4).

7. Process according to Claim 6, characterised in that the axis of the rotation movement coincides with the axis (17) of the raw material source.

8. Device for the performance of the process according to any of Claims 1 to 7, comprising means (7, 29, 30, 31) for generating an electron beam (3) and magnetic coils (11, 12) which are arranged in a plane in the area of the electron beam (3), where the axes (15, 16) of these magnetic coils (11, 12) run approximately at right angles to the axis (17) of the electron beam (3) and approximately at right angles to each other, characterised in that a video system is provided comprising:
- a video camera (42) arranged outside the vacuum chamber (1),
- a closeable window (53) in the wall of the vacuum chamber through which the video camera can view the vaporization source (4), where the axis of the video camera is essentially aligned with the centre point of the source, and
- an image analyser (43) connected to a computer (51) for controlling the supply (44, 45) to the magnetic coils (11, 12).

## Revendications

1. Procédé pour guider et centrer un faisceau électronique (3) à l'aide d'un champ magnétique orthogonal par rapport à l'axe (17) du faisceau électronique (3) dans une installation de revêtement sous vide, selon lequel le faisceau électronique (3) est guidé dans une chambre à vide (1) d'une cathode (7) à une source de matière première (4), une tache cathodique est produite à cet endroit, la surface de la source de matière première (4) est chauffée et fondue à l'aide du faisceau électronique (3) et ladite source (4) est déplacée suivant la fusion, caractérisé en ce que l'écart entre la tache cathodique produite à l'aide du faisceau électronique (3) et le centre de la source de matière première (4) est enregistré à l'aide d'un système vidéo (42, 43, 52, 53), et les signaux ainsi déterminés sont utilisés pour la configuration du champ magnétique, pour guider et centrer le faisceau électronique (3).

2. Procédé selon la revendication 1, caractérisé en ce que deux bobines d'électro-aimants croisées (11, 12) sont utilisées pour centrer le faisceau électronique (3).

3. Procédé selon l'une des revendications 1 ou 2, caractérisé en ce que le système vidéo comprend une caméra vidéo (42) qui est orientée vers le milieu de la barre ou de la source de matière première (4) et qui est reliée, pour la détection de signaux de luminance sur la surface de la source de matière première (4), à un analyseur d'images (43) à l'aide duquel les signaux de luminance supérieurs à une valeur seuil réglable sont détectés et enregistrés, étant précisé que les appareils d'alimentation (44, 45) des bobines d'électro-aimants orthogonales (11, 12) destinées à centrer le faisceau électronique (3) sont commandés à l'aide de ces signaux et par l'intermédiaire d'un calculateur (51) de telle sorte que la zone présentant la plus grande luminance sur la surface de la source de matière première (4) vienne se situer au milieu de la source d'évaporation.

4. Procédé selon l'une des revendications 1 à 3, caractérisé en ce que pour le centrage du faisceau électronique (3), on travaille avec une puissance réduite, de telle sorte que le produit à fondre de la source d'évaporation soit seulement chauffé, mais pas évaporé.

5. Procédé selon l'une des revendications 1 à 4, caractérisé en ce que la caméra vidéo (42) est montée pivotante pour l'ajustement et le centrage lors d'un déplacement de la source de matière première (4).

6. Procédé selon l'une des revendications 1 à 5, caractérisé en ce que le champ magnétique est superposé par un champ magnétique rotatif généré à l'aide d'un signal alternatif, pour la production d'une rotation du faisceau électronique (3) autour de l'axe (17) de la source de matière première, en vue d'obtenir une fusion régulière de la source de matière première (4).

7. Procédé selon la revendication 6, caractérisé en ce qu'on fait coincider l'axe du mouvement de rotation avec l'axe (17) de la source de matière première.

8. Dispositif pour la mise en oeuvre du procédé selon l'une des revendications 1 à 7, comprenant des moyens (7, 29, 30, 31) pour produire un faisceau électronique (3), et des bobines d'électro-aimants (11, 12) qui sont disposées dans un plan dans la zone du faisceau électronique (3), les axes (15, 16) de ces bobines d'électro-aimants (11, 12) étant sensiblement à angle droit par rapport à l'axe (17) du faisceau électronique (3) et l'un par rapport à l'autre, caractérisé en ce qu'il est également prévu un système vidéo comprenant :
- une caméra vidéo (42) disposée à l'extérieur de la chambre à vide (1),
- une fenêtre apte à être fermée (53) dans la paroi de la chambre à vide, pour que la caméra vidéo voie la source d'évaporation (4), l'axe de la caméra vidéo étant dirigé sensiblement vers le milieu de la source, et
- un analyseur d'images (43) accouplé à un calculateur (51) pour la commande de l'alimentation (44, 45) des bobines d'électro-aimants (11, 12).
